# NEUE EUROPÄISCHE PATENTSCHRIFT

(11) **EP 3 939 163 B2**
(45) Veröffentlichungstag und Bekanntmachung des Hinweises auf die Entscheidung über den Einspruch: **09.09.2026**
(45) Hinweis auf die Patenterteilung: 12.04.2023
(21) Anmeldenummer: 20706416.3
(22) Anmeldetag: 13.02.2020
(51) Int. Cl.: H03K 17/96, G06F 3/01

(54) **BEDIENEINHEIT FÜR EIN FAHRZEUG**
CONTROL UNIT FOR A VEHICLE
UNITÉ DE COMMANDE POUR UN VÉHICULE

(30) Priorität: 13.03.2019 DE 102019106441; 12.04.2019 DE 102019109785
(43) Veröffentlichungstag der Anmeldung: 19.01.2022
(73) Patentinhaber: AUO Mobility Solutions Germany GmbH, 59557 Lippstadt (DE)
(72) Erfinder: KIRSCH, Stefan, 59557 Lippstadt (DE); KEMPPINEN, Pasi, 59557 Lippstadt (DE)
(74) Vertreter: dompatent
(86) Internationale Anmeldenummer: PCT/EP2020/053726
(87) Internationale Veröffentlichungsnummer: WO 2020/182405

(56) Entgegenhaltungen:
- EP-A2- 2 348 384
- DE-A1- 102017 104 541
- US-A1- 2013 201 127

## Beschreibung

Die vorliegende Anmeldung nimmt die Priorität der beiden nationalen deutschen Patentanmeldungen 10 2019 106 441.4 vom 13.03.2019 und 10 2019 109 785.1 vom 12.04.2019 in Anspruch.

Die Erfindung betrifft eine Bedieneinheit für ein Fahrzeug mit oszillationsfreiem haptischen Feedback.

Systeme für Haptisches Feedback bestehen typischerweise aus einem Aktuator, der eine Kraft aufbringt, und einem mechanischen System, auf das diese Kraft wirkt. Die daraus resultierende Bewegung kann vom Benutzer gespürt werden.

Um diese Bewegung überhaupt zuzulassen, ist das mechanische System in der Regel federnd gelagert. Mechanische Feder-Masse-Systeme haben zwangsläufig Resonanzfrequenzen, mit denen sie oszillieren können.

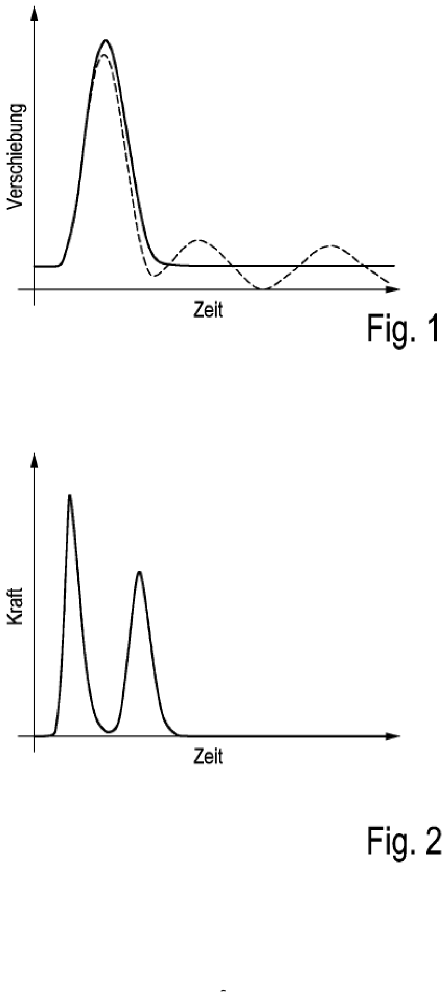

Es gibt Haptic Feedback Ansätze, bei denen ganz bewusst eine dieser Resonanzfrequenzen angeregt wird, um die daraus resultierende sinusförmige Schwingung fühlbar zu machen. Der Nachteil dieses Ansatzes ist eine meist als qualitativ minderwertig, bzw. als "schwammig" beschriebene Anmutung. Daher bevorzugt man einen pulsförmigen Wegverlauf des mechanischen Systems (siehe die durchgezogene Linie im Diagramm der Fig. 1).

Um dieses Bewegungsprofil zu erreichen, bedarf es einer an die Resonanzfrequenzen des Systems angepassten Kraftanregung, die vom prinzipiellen Verlauf her typischerweise wie im Diagramm der Fig. 2 aussieht. Der Abstand der beiden Maxima muss exakt an die Frequenz der zu unterdrückenden Oszillation angepasst sein. Andernfalls tritt diese Oszillation in Form von Nachschwingen nach dem eigentlichen Puls auf (siehe die gestrichelte Linie im Diagramm der Fig. 1). Diese Nachschwingung vermindert deutlich spürbar die Qualität des haptischen Feedbacks und muss daher vermieden werden.

Es ist bekannt, das schwingende haptische Feedback-System durch Ansteuerung des Antriebs (Aktuators) in Form eines Pulses zu einem bestimmten Zeitpunkt zum Stillstand bringen zu wollen (siehe z.B. DE-A-10 2013 007 962, DE-A-10 2014 019 162, DE-B-10 2007 058 110 und EP-A-2 348 384).

Aus US-A-2013/201127 ist eine manuell betätigbare Bedieneinheit mit den Merkmalen des Oberbegriffs des Anspruchs 1 bekannt.

Aufgabe der Erfindung ist es, eine Bedieneinheit mit oszillationsfreiem haptischen Feedback zu schaffen.

Zur Lösung dieser Aufgabe wird mit der Erfindung eine Bedieneinheit für ein Fahrzeug vorgeschlagen, die versehen ist mit
- einem Gehäuse,
- einem Bedienelement, das in und/oder an dem Gehäuse elastisch gelagert ist,
- wobei das elastisch gelagerte Bedienelement ein Feder-Masse-System bildet, das eine konstruktionsbedingte Resonanzfrequenz aufweist,
- einem Aktuator zum impulsförmigen mechanischen Anregen des Bedienelements und
- einer Ansteuereinheit zum Ansteuern des Aktuators bei einer manuellen Betätigung des Bedienelements,
- wobei die Resonanzfrequenz konstruktionsbedingt oberhalb der größten, typischerweise von den Rezeptoren für das haptische Feedback und/oder für das taktile Empfinden einer Person noch erfassbaren Grenzfrequenz liegt und
- wobei das Frequenzspektrum des mechanischen Impulses bei der Resonanzfrequenz und/oder bei einer der Oberwellen der Resonanzfrequenz keine Frequenzanteile aufweist, indem das Leistungsdichtespektrum oberhalb der Grenzfrequenz energiefrei ist.

Erfindungsgemäß wird das Feder-Masse-System derart ausgelegt, dass seine Resonanzfrequenz außerhalb desjenigen Frequenzbandes liegt, innerhalb dessen eine Person für taktiles Empfinden, d.h. für das "Fühlen" von mechanischen Schwingungen sensitiv ist. Typischerweise liegt die von den Hautrezeptoren für das haptische Feedback und/oder für das taktile Empfinden einer Person noch erfassbare Grenzfrequenz bei 400 Hz.

Erfindungsgemäß weist das Frequenzspektrum des mechanischen Impulses bei der (ersten) Resonanzfrequenz (Resonanzgrundfrequenz) und/oder bei einer der Oberwellen der Resonanzfrequenz keine Frequenzanteile auf. Dies äußert sich beispielsweise dadurch, dass das Leistungsdichtespektrum oberhalb der Grenzfrequenz energiefrei ist. Damit erfolgt keine Anregung des Feder-Masse-Systems bei der Resonanzfrequenz.

In weiterer zweckmäßiger Ausgestaltung der Erfindung kann die Resonanzfrequenz gemäß der nachfolgenden Formel durch die Wahl der Masse und/oder der Federkonstante des Feder-Masse-Systems definiert werden: $f = \frac{1}{2 π} \sqrt{\frac{k}{m} ,}$ wobei m die Masse des Feder-Massen-Systems, k die Federkonstante des Feder-Massen-Systems und f die Resonanzfrequenzen beschreiben.

In einer typischen Realisierung der Bedieneinheit handelt es sich bei dieser um ein Touchpad oder um ein Touchscreen mit einer berührungsempfindlichen Oberfläche.

Typischerweise ist vorgesehen, dass die Bedieneinheit dazu ausgelegt ist, eine valide Betätigung in Abhängigkeit vom Betätigungsdruck oder von der Betätigungskraft bzw. von dem Verlauf des Betätigungsdrucks oder der Betätigungskraft zu erkennen.

In weiterer zweckmäßiger Ausgestaltung der Erfindung kann der Aktuator als Zugankermagnet, als Tauchspulen- oder als Piezoantrieb ausgeführt sein.

Anhand der Zeichnung wird ein nicht erfindungsgemäßes Beispiel beschrieben. In der Zeichnung sind verschiedene Diagramme gezeigt, auf die bereits weiter oben eingegangen worden ist und im Folgenden eingegangen wird.

Wie vorstehend beschrieben, hat ein Masse-Feder-System Resonanzfrequenzen, mit denen es oszilliert, sofern es entsprechend angeregt wird. Die Rezeptoren für haptisches Empfinden im Finger sprechen vorwiegend auf Frequenzen unterhalb einer Grenzfrequenz von z.B. 200 Hz an. Gelingt es, das mechanische System so zu gestalten, dass seine Resonanzfrequenzen alle oberhalb dieser Schwelle, z.B. 200 Hz liegen, so kann ein haptisch gut spürbarer Puls erzeugt werden, der gar nicht nachschwingen kann.

Die erste Resonanzfrequenz eines Masse-Feder-Systems gehorcht der Gleichung $f = \frac{1}{2 π} \sqrt{\frac{k}{m}} .$

Somit kann durch die Wahl der Größe der Masse m und der Federrate *k* die Lage der ersten Resonanzfrequenz im Spektrum abgeschätzt und aktiv beeinflusst werden.

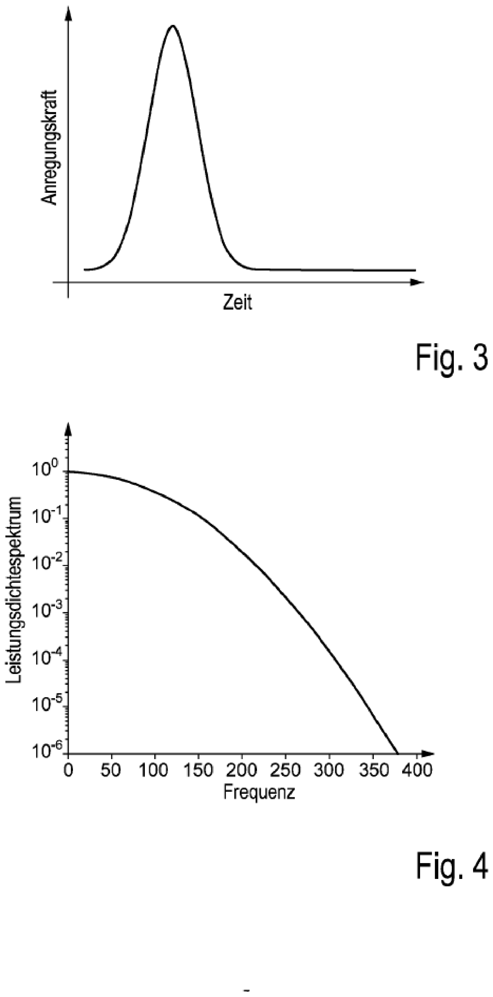

Des Weiteren wird das Frequenzspektrum des Anregungssignals dahingehend beeinflusst, dass keine Resonanzfrequenzen angeregt werden, aber dennoch ein für den Finger spürbarer Puls hervorgerufen wird. Als Resultat einer beispielhaften Wahl des Anregungssignals auf den in Fig. 3 gezeigten Verlauf verwiesen, der das in Fig. 4 gezeigte Leistungsdichtespektrum aufweist. Im logarithmischen Maßstab des Diagramms der Fig. 4 ist klar zu erkennen, dass die (normierte) Energie mit steigender Frequenz drastisch abnimmt und so oberhalb einer Schwelle, z.B. 200 Hz, keine Eigenschwingungen mehr nennenswert angeregt werden, womit die Aufgabenstellung erfüllt ist.

Es sei darauf hingewiesen, dass das erfindungsgemäße Systemverhalten nichts mit Dämpfung zu tun hat. Das Prinzip, auf dem die Erfindung beruht, lautet daher eher "Was nicht angeregt wird, muss auch nicht abgebremst werden". Damit ist ein so genannter Bremspuls gar nicht erst erforderlich. Die Auslenkung folgt stattdessen direkt der anregenden Kraft.

Das Neue und Vorteilhafte an der vorliegenden Erfindung ist die Kombination aus einem Anregungssignal, insbesondere seiner spektralen Anteile, und einem mechanischen Design, das Oszillationen nur außerhalb des angeregten Frequenzspektrums zulässt.

### Literaturverzeichnis

1. DE-A-10 2013 007 962
2. DE-A-10 2014 019 162
3. DE-B-10 2007 058 110
4. EP-A-2 348 384

## Patentansprüche

1. Bedieneinheit für ein Fahrzeug, mit
- einem Gehäuse,
- einem Bedienelement, das in oder an dem Gehäuse elastisch gelagert ist,
- wobei das elastisch gelagerte Bedienelement ein Feder-Masse-System bildet, das eine konstruktionsbedingte Resonanzfrequenz aufweist,
- einem Aktuator zum impulsförmigen mechanischen Anregen des Bedienelements und
- einer Ansteuereinheit zum Ansteuern des Aktuators bei einer manuellen Betätigung des Bedienelements,
- wobei die Resonanzfrequenz konstruktionsbedingt oberhalb der größten, typischerweise von Rezeptoren für ein haptisches Feedback und/oder für ein taktiles Empfinden einer Person noch erfassbaren Grenzfrequenz liegt,
**dadurch gekennzeichnet,**
- **dass** die Grenzfrequenz 400 Hz beträgt und
- **dass** das Frequenzspektrum des vom Aktuator angeregten mechanischen Impulses bei der Resonanzfrequenz keine Frequenzanteile aufweist, indem das Leistungsdichtespektrum des mechanischen Impulses oberhalb der Grenzfrequenz energiefrei ist.

2. Bedieneinheit nach Anspruch 1, **dadurch gekennzeichnet, dass** die Masse und/oder die Federkonstante des Feder-Masse-Systems zur Definition von dessen Resonanzfrequenz gemäß der nachfolgenden Formel gewählt wird/werden: $f = \frac{1}{2 π} \sqrt{\frac{k}{m}} ,$ wobei m die Masse des Feder-Massen-Systems, k die Federkonstante des Feder-Massen-Systems und f die Resonanzfrequenzen beschreiben.

3. Bedieneinheit nach Anspruch 1 oder 2, **dadurch gekennzeichnet, dass** die Bedieneinheit ein Touchpad oder ein Touchscreen mit einer berührungsempfindlichen Oberfläche aufweist.

4. Bedieneinheit nach einem der Ansprüche 1 bis 3, **dadurch gekennzeichnet, dass** die Bedieneinheit dazu ausgelegt ist, eine valide Betätigung in Abhängigkeit vom Betätigungsdruck oder von der Betätigungskraft bzw. von dem Verlauf des Betätigungsdrucks oder der Betätigungskraft zu erkennen.

5. Bedieneinheit nach einem der Ansprüche 1 bis 4, **dadurch gekennzeichnet, dass** der Aktuator als Zugankermagnet, als Tauchspulen- oder als Piezoantrieb ausgeführt ist.

## Claims

1. An operating unit for a vehicle, comprising
- a housing,
- an operating element elastically mounted in or on the housing,
- wherein the elastically mounted operating element forms a spring-mass system having a construction-related resonance frequency,
- an actuator for pulse-shaped mechanical excitation of the operating element, and
- a control unit for controlling the actuator when manually actuating the operating element,
- wherein the resonance frequency is, due to construction, above the highest cut-off frequency that can typically still be detected by receptors for haptic feedback and/or for tactile sensation of a person,
**characterized in that**
- the fundamental frequency is 400 Hz, and
- the frequency spectrum of the mechanical pulse at the resonance frequency excited by the actuator has no frequency components **in that** the power density spectrum of the mechanical pulse above the cut-off frequency is energy-free.

2. The operating unit according to claim 1, **characterized in that** the mass and/or the spring constant of the spring-mass system is/are selected for definition of its resonance frequency according to the following formula: $f = \frac{1}{2 π} \sqrt{\frac{k}{m}} ,$ wherein m describes the mass of the spring-mass system, k describes the spring constant of the spring-mass system and f describes the resonance frequencies.

3. The operating unit according to claim 1 or 2, **characterized in that** the operating unit has a touchpad or a touchscreen with a touch-sensitive surface.

4. The operating unit according to any one of claims 1 to 3, **characterized in that** the operating unit is configured to detect a valid actuation as a function of the actuation pressure or actuation force or the course of the actuation pressure or actuation force.

5. The operating unit according to any one of claims 1 to 4, **characterized in that** the actuator is designed as a tension rod magnet, as a plunger coil drive or as a piezo drive.

## Revendications

1. Unité de commande pour un véhicule, dotée
- d'un boîtier,
- d'un élément de commande disposé de manière élastique dans ou sur le boîtier,
- dans laquelle l'élément de commande disposé de manière élastique forme un système ressort-masse comportant une fréquence de résonance dépendant de la conception,
- d'un actionneur destiné à l'excitation mécanique sous forme d'impulsions de l'élément de commande et
- d'une unité de pilotage destinée au pilotage de l'actionneur en cas d'actionnement manuel de l'élément de commande,
- dans laquelle la fréquence de résonance se trouve en raison de la conception au-dessus de la plus haute fréquence limite typiquement encore perceptible par les récepteurs pour un retour haptique et/ou pour un ressenti tactile d'une personne,
**caractérisée**
- **en ce que** la fréquence fondamentale est 400 Hz, et
- **en ce que** le spectre de fréquences de l'impulsion mécanique excitée par l'actionneur à la fréquence de résonance ne comporte aucune composante de fréquence où le spectre de densité de puissance de l'impulsion mécanique est sans apport d'énergie au-dessus de la fréquence limite.

2. Unité de commande selon la revendication 1, **caractérisée en ce que** la masse et/ou la constante de ressort du système ressort-masse est/sont sélectionnée(s) selon la formule ci-dessous afin de définir la fréquence de résonance de celui-ci : $f = \frac{1}{2 π} \sqrt{\frac{k}{m}}$ dans laquelle m représente la masse du système ressort-masse, k la constante de ressort du système ressort-masse et f la fréquence de résonance.

3. Unité de commande selon la revendication 1 ou 2, **caractérisée en ce que** l'unité de commande comporte un clavier tactile ou un écran tactile doté d'une surface sensible au toucher.

4. Unité de commande selon l'une des revendications 1 à 3, **caractérisée en ce que** l'unité de commande est configurée afin de reconnaître un actionnement valide en fonction de la pression d'actionnement ou de la force d'actionnement, ou bien en fonction de l'évolution de de la pression d'actionnement ou de la force d'actionnement.

5. Unité de commande selon l'une des revendications 1 à 4, **caractérisée en ce que** l'actionneur est réalisé comme entraînement à bobine mobile ou piézoélectrique ou comme aimant à tirant.
